Europäisches Patentamt

European Patent Office

Office européen des brevets

(11) Publication number: **0 083 394**
**B1**

# EUROPEAN PATENT SPECIFICATION

(45) Date of publication of patent specification: **09.04.86**

(21) Application number: **82109182.4**

(22) Date of filing: **05.10.82**

(51) Int. Cl.⁴: **G 03 B 41/00,** G 02 B 26/10,
G 03 F 7/20

(54) A method and apparatus for providing a uniform illumination of an area.

(30) Priority: **31.12.81 US 336484**

(43) Date of publication of application:
**13.07.83 Bulletin 83/28**

(45) Publication of the grant of the patent:
**09.04.86 Bulletin 86/15**

(84) Designated Contracting States:
**DE FR GB**

(56) References cited:
EP-A-0 018 249
FR-A-1 000 428
US-A-3 925 785
US-A-4 028 547
US-A-4 180 307

JOURNAL OF APPLIED PHYSICS, vol. 47, no 12,
December 1976, pages 5450-5459, New York,
USA E. SPILLER et al.: "Application of
synchrotron radiation to x-ray lithography"

(73) Proprietor: **International Business Machines
Corporation
Old Orchard Road
Armonk, N.Y. 10504 (US)**

(72) Inventor: **Grobman, Warren David
2892 Saddle Ridge Drive
Yorktown Heights New York 10598 (US)**

(74) Representative: **Lewis, Alan John
IBM United Kingdom Patent Operations
Hursley Park
Winchester, Hants, S021 2JN (GB)**

(56) References cited:

**APPLIED PHYSICS LETTERS, vol. 29, no. 6, 15th
September 1976, pages 370-372, New York,
USA B. FAY et al.: "X-ray replication of masks
using the synchrotron radiation produced by
the ACO storage ring"**

## Description

This invention relates to a method and apparatus for providing uniform illumination across an area.

High resolution lithography has become very important for increasing the performance of large scale integrated circuits, and as a tool for use in basic research. In the case of large scale integration, technology advances proceed generally through both increased circuit cleverness and through increased density of circuits achieved by continually reducing the lithography linewidth w. While the reduction of w is one of the key requirements in advanced microfabrication, it is also the common situation that an increased aspect ratio of resist exposures occurs as w decreases. In the case of research into scientific phenomena, fabrication of microstructures of width w which are small compared with some characteristic length I of a phenomenon permits one to perform experiments in a new regime characterised by w/l much less than 1.

X-ray lithography has produced significant advances in microcircuit fabrication both in the area of reducing w and in its increased ability to achieve high aspect ratio, or to pattern fine lines over severe topography, as compared to more classical electron beam or optical techniques. X-ray lithography is described in many papers, including a comprehensive review by Spiller and Feder, "X-Ray Lithography and X-Ray Optics", ed. H. J. Queisser, Springer, Berlin, pp. 35, 1977. The unique strengths of x-ray lithography are due to the weak scattering of x-rays in resist materials. In contrast, electron beam acuity for microfabrication is limited by strong scattering of electrons in matter, while optical lithography is limited by diffraction phenomena.

X-ray lithography is a proximity printing technique in which a mask containing x-ray transparent and opaque regions is imaged onto a resist-coated wafer which is placed close to and parallel to the mask, as described by W. Grobman in Handbook of Synchrotron Radiation, Vol. 1, edited by E. E. Koch et al, North Holland, Amsterdam, 1980. The imaging is done by projecting x-rays from a source through the mask and onto the wafer. The size of the source and its distance from the mask determine the resolution-limiting penumbra, and the image distortion of runout. In addition to the source geometry, the x-ray flux from the source onto the mask and its spectral distribution versus photon energy are of great importance, since they directly determine the throughput of the process (i.e., the rate of resist exposure) as well as the mask contrast (i.e., the ratio of power transmitted through "clear" regions of the mask to that transmitted by areas covered by an x-ray absorber).

Although many types of x-ray sources can be used, the storage ring offers important advantages over conventional sources, in the areas of penumbra, runout, throughput, and spectral distribution. Experiments and analyses involving synchrotron radiation x-ray lithography have been reported, as can be seen by referring to the aforementioned review by Spiller and Feder, and by referring to Fay and Trotel, Appl. Phys. Lett. 29, 370 (1976), and Spiller et al, J. Appl. Phys. 47, 5450, (1976). A synchrotron storage ring is a well known radiation source, and the spectral distribution available therefrom is well known in the art. The storage ring is a copious x-ray source which yields high throughput, compared to more conventional sources. Another advantageous feature of the storage ring source relates to the size of the source and its distance from the mask. Typically, the source-mask distance is large while the size of the source is small, which reduces resolution-limiting penumbra and image distortion due to runout.

While storage rings provide advantages, it is difficult to obtain uniform illumination over an x-ray mask area when such a source is used. The beam from a storage ring source is divergent in the horizontal plane (y direction) but highly collimated in a vertical plane (z direction). It is therefore similar to a horizontal fan of radiation which then must be moved vertically in order to expose a mask in the z direction. Still further, the horizontal divergence of the beam means that the illumination along the y direction may vary in different parts of the beam if a horizontally condensing optical system is used, if this beam is traversed in the z direction. The nature of the output beam from the storage ring is such that it is difficult to provide uniform illumination in the vertical direction with such a beam, and also it is difficult to multiply the intensity of the storage ring beam onto the x-ray mask. There is no known prior art which deals with the problem of making a synchrotron x-ray beam more uniform, although the use of collimators is known for providing stationary direction of the x-ray beam. Additionally, a mirror has been used in the x-ray path as a "low pass filter" to reduce the hard x-ray flux from a high energy ring. A mirror has also been used to focus x-rays in spectroscopic systems, but has not been applied in lithography systems where masks have to be uniformly illuminated.

In lithography systems, it is known from US—A—4208547 to move the mask and the wafer in order to provide x-ray illumination in the z direction from a synchrotron source. However, this involves a complex apparatus because precision alignment must be maintained between the mask and the wafer, and the mask and wafer have to be moved simultaneously as a unit. This complex apparatus cannot provide fast scanning in the z direction, and consequently adverse thermal effects occur at the mask and wafer.

According to the invention there is provided an apparatus for providing substantially uniform illumination across a two-dimensional area, comprising a source of an input beam of radiation which is divergent in one direction, reflecting means for collimating said divergent input beam and for providing a reflected output beam to said area to be illuminated, characterised by means for moving said reflecting means with a velocity which varies with time such that the product of the flux in said reflected beam and the velocity of movement of said reflected beam in said area is substantially constant.

Further according to the invention there is provided a method for providing substantially uniform illumination of a two dimensional area with an input beam of radiation which is divergent in one direction, which method comprises sending said beam from a source to a reflecting means from which it is reflected to said area to be illuminated, and collimating said beam to provide a collimated reflected beam to said area, characterised by changing the angle between said input beam and said reflecting means such that the product of the flux in said reflected beam and the velocity of movement of said beam is approximately constant with time as said reflected beam moves across said area.

Preferably the input beam is an x-ray output beam of a synchrotron, which is highly divergent in a horizontal direction, but also highly collimated in a vertical direction. A cylindrical mirror is used to focus the beam in the horizontal direction to thereby collimate it to an increased intensity, and the now collimated beam is scanned in the vertical direction by moving (e.g., rotating) the cylindrical mirror. A plane mirror and other mirrors with shapes other than cylindrical may be used in this invention.

The mirror is positioned at grazing incidence with respect to the divergent radiation beam for reducing divergence, and is moved in a manner which is not time linear. That is, the change in grazing angle is such that z direction illumination of the area is uniform. The time dependence of the grazing angle is adjusted in such a way as to compensate for the variable collimation of the beam, which is a function of the grazing angle, and thus of the position of an area to be illuminated.

The mirror can be moved rapidly to provide rapid scanning of the radiation beam across the area. Since only the mirror is moved, rapid scanning will occur and the time dependence of the grazing angle is made periodic in time with a fundamental frequency sufficiently large that the temperature rise on the area (such as a mask and a wafer) cannot follow the sweeping beam. This leads to uniform heating of the mask and wafer, in contrast to systems wherein the beam is stationary and the mask-wafer combination is moved with respect to the input beam.

The invention is particularly suited for use in x-ray lighography systems where the input x-ray beam is provided by a synchrotron. However, the concept of the invention has applicability to other beams, such as photon and electron beams which are divergent in one direction and very collimated in a second direction along which the beam is to be scanned.

An example is a laser beam which is moved back and forth at a first speed in a horizontal plane, and moved vertically at a different speed determined by the uniformity of illumination over an area, where the speed of movement in the second direction compensates for the variable collimation of the beam and its position on the area to be illuminated.

It can be shown that a linear or non-linear velocity with time of the beam in a vertical direction is suitable to provide uniform illumination of a two-dimensional area where the specific nature of the time dependence of the mirror motion depends on the figure of the mirror, and on the spectral character of the radiation and its horizontal intensity distribution. A closed loop servo system can be used to move the mirror in such a way as to produce this uniform illumination.

The invention will now be described by way of example with reference to the accompanying drawings in which:—

Fig. 1 illustrates the basic features of an x-ray lithography exposure process, and illustrates the definition of certain parameters, such as the penumbra p and the image distortion of runout $\delta R$;

Fig. 2 illustrates the spectrum and geometry of a radiation beam produced by a storage ring, such as synchrotron;

Fig. 3 illustrates an x-ray lithography beamline system for providing a collimated beam on an x-ray mask/wafer plane wherein uniform exposure of a two-dimensional area can be achieved, using a source of radiation the input beam shown in Fig. 2;

Fig. 4 illustrates the various arcs of radiation which are formed over a two-dimensional area using the cylindrical mirror apparatus of Fig. 3, and illustrates the uniformity of exposure of a two-dimensional mask area;

Fig. 5 is a plot of the mirror reflectively versus photon energy for five different grazing angles $\alpha$. In this system, the reflectivity, and therefore the efficiency of transmission of radiation to the mask, decreases rapidly as $\alpha$ increases;

Fig. 6 is a schematic diagram of an x-ray lithography system in accordance with the present invention, where the grazing angle $\alpha$ is automatically adjusted by a closed loop system to provide uniform illumination of a mask surface; and

Fig. 7 is an electrical circuit diagram of a circuit which can be used to provide a reference signal in the system of Fig. 6.

Various types of lithography printing processes are known in the art. An x-ray lithography system is described by Grobman in Proceedings of the Inter. Electron Devices Meeting) IEDM) (Dec. 1980, Wash., D.C), pp. 415—419. This lithography consists of proximity printing of a mask 10 onto a wafer 12. The mask generally is comprised of a thin continuous substrate 14 on which a patterned x-ray absorbing layer 16 is fabricated. The wafer 12 has a resist layer 18 thereon which is to be exposed through mask 10.

A source 20 having a size $d_o$ is located at a

distance $D_o$ from mask 10. The source size $d_o$ and its distance $D_o$ from the mask, as well as the mask-wafer spacing S, determine the resolution limiting penumbra p and the image distortion of runout δR. An especially advantageous feature of a storage ring source, such as a synchrotron, is a geometrical one that is due to the large source-mask distance $D_o$, and the small source size $d_o$.

The resolution of the exposed resist distribution in x-ray lithography depends on the photoelectron range and on fresnel diffraction. For wavelengths λ of approximately 10Å, Fresnel diffraction predominates and can be calculated for the case of exposure of a line of width w, for a mask separated by a distance S from resist layer 18.

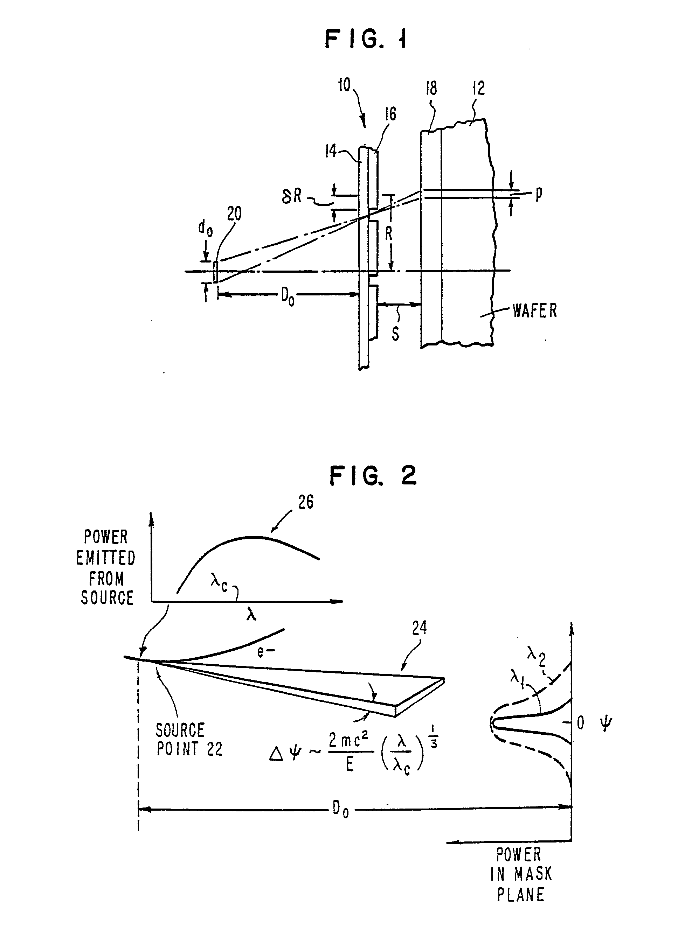

Fig. 2 shows the type of spectrum obtained from a storage ring source, and the geometry of such a source-mask configuration. The source is considered to be a point 22 from which a divergent beam 24 is emitted. In Fig. 2, the spectrum 26 of power emitted from the source as a function of wavelength λ is shown, $λ_c$ being a characteristic wavelength used to describe the radiation in devergent beam 24. The vertical width of the beam $Δψ$ is different for each different wavelength λ.

Fig. 2 shows the spectrum of power emitted from the source and also the power delivered to the mask plane. The width ψ of power delivered to the mask plane is shown for two wavelengths $λ_1$ and $λ_2$. As is apparent, the power distribution in the mask plane depends upon the wavelength. This is one reason why it is difficult to provide uniform y—z illumination of a mask area with a beam such as beam 24 in Fig. 2. It is a problem that the present invention solves.

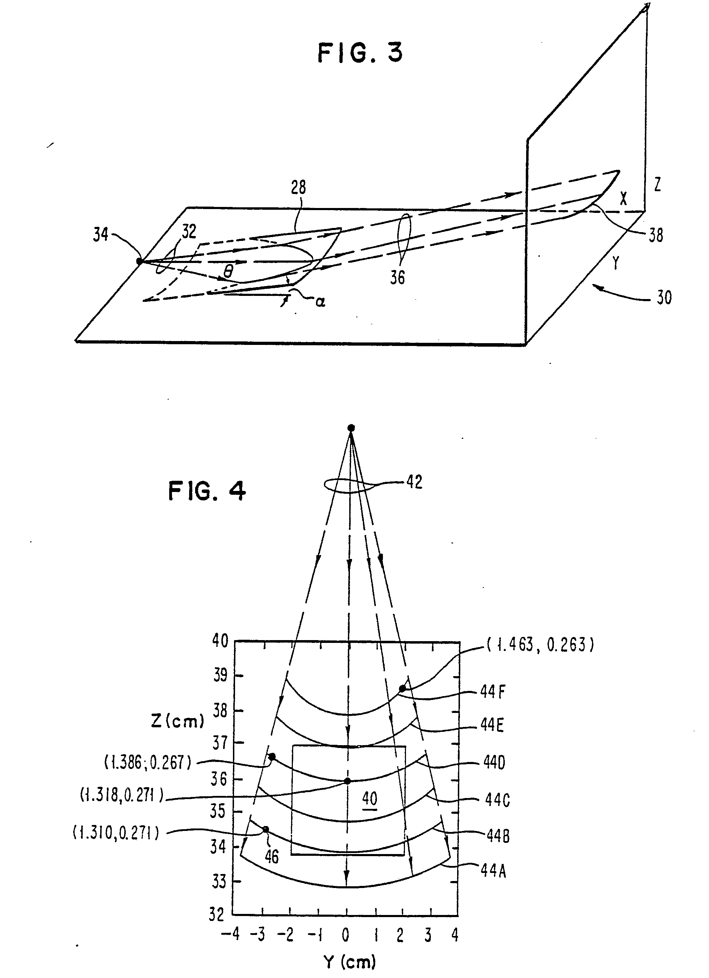

Uniform Y—Z Illumination (Figs. 3—7)

These figures illustrate an apparatus which will provide a uniform power distribution of radiation across a mask/wafer plane. Fig. 3 illustrates the concept of the invention, wherein the mirror 28 has a cylindrical shape and is used to collimate an input radiation beam in a horizontal plane, the movement of mirror 28 being used to displace the collimated beam in a vertical direction across a plane 30, such as a mask/wafer plane. The divergent input beam 32 is provided by the source 34 and strikes mirror 28 at a grazing angle α, where α is the angle between the mirror axis and the plane of the beam 30.

As is apparent from Fig. 3, the rays comprising beam 32 are collimated in a horizontal direction (Y) and strike the mask/wafer plane 30 along a curved arc 38. As the angle α is changed, arc 38 will change in length as it moves vertically in a Z direction across plane 30.

A surprising feature of this invention is that the power incident on the plane 30 is substantially the same at all points along the arc 38. Since the transmission coefficient for different wavelengths is different, one would expect that the use of the cylindrical mirror 28 would cause a change in the power distribution along the arc 38, and also from arc to arc as the angle α is changed. Calculation has shown that the power incident on plane 30 is substantially the same on all points of the arc 38, but that the power incident on plane 30 will change from arc to arc as the angle α is changed. To provide uniform illumination along the Z direction, the rate of movement of cylindrical mirror 28 is chosen in such a way that the time dependence of the grazing angle α(t) is adjusted to compensate for the variable collimation of the beam as α changes. Thus, this compensates for the different positions on the mask which are to be illuminated. When the velocity of movement of the mirror is adjusted, the angle α will be adjusted also, to take into account that the length of each arc 38 depends upon the angle α. By making the product of the incident radiation flux and the velocity of the beam in the Z direction a constant, uniform Z illumination of plane 30 will be obtained.

Fig. 4 is a plot indicating the coverage of illumination on a mask area for different grazing angles. The plane of the mask is defined by the Y—Z coordinates (see Fig. 3, also) and the mask area is defined by the square boundary 40. The scanning radiation beam from the cylindrical mirror is depicted by the rays collectively labelled 42. The scanning beam produces arcs of radiation 44A, 44B, . . ., 44F. At various points along each of the arcs two numbers appear in parenthesis. The first of these numbers represents the grazing angle α in degrees, while the second number represents the power incident on the resist layer to be exposed, for each milliradian of emitted beam. For example, point 46 on arc 44B was produced by a scanning beam incident on the cylindrical mirror at a grazing angle of 1.310 degrees, and yielded a power on the resist layer of 0.271 (in arbitrary units per milliradian of emitted beam).

The diagram of Fig. 4 was obtained in an x-ray lithography system where the distance from the source to the cylindrical mirror was 2.3 m, while the distance from the mirror to the mask plane was 7.7 m. In this system, the ratio of the change of flux δF to the flux F in the centre of the mask area is approximately 0.01, indicating a very small change in illumination over the entire mask area due simply to changes in grazing angle and consequently in reflectivity.

It would have been expected that the curvature of each arc of radiation in the mask plane would have changed as the angle α changed. However, it has been experimentally and computationally determined that a plurality of concentric arcs is obtained having substantially the same curvature over an area sufficient to illuminate masks that are typically used in such a system. However, the arc length changes as the grazing angle changes, and this means that the power density within each arc would be expected to be different from that in every other arc. It has been computationally verified that the power distribution along each arc, and from arc-to-arc is very similar over the entire mask area when the arcs of radiation are scanned in the Z direction at a velocity which is periodic with time.

This collimation system provides good collimation in the Y direction, so that increased power is incident on the mask, and also provides scanning of that power in the Z direction. Thus, the system is sufficient in terms of the amount of power delivered to the mask with this type of input beam, and large mask areas can be illuminated in a substantially uniform way.

The cylindrical scanning mirror 28 in Fig. 3 is chosen to have a high reflectivity for the wavelengths present in the input beam 32 (Fig. 3). For x-ray radiation, the mirror is typically quartz coated with a heavy metal, such as gold. Gold is preferred because it is a heavy metal which provides a smooth surface and doesn't readily oxidize.

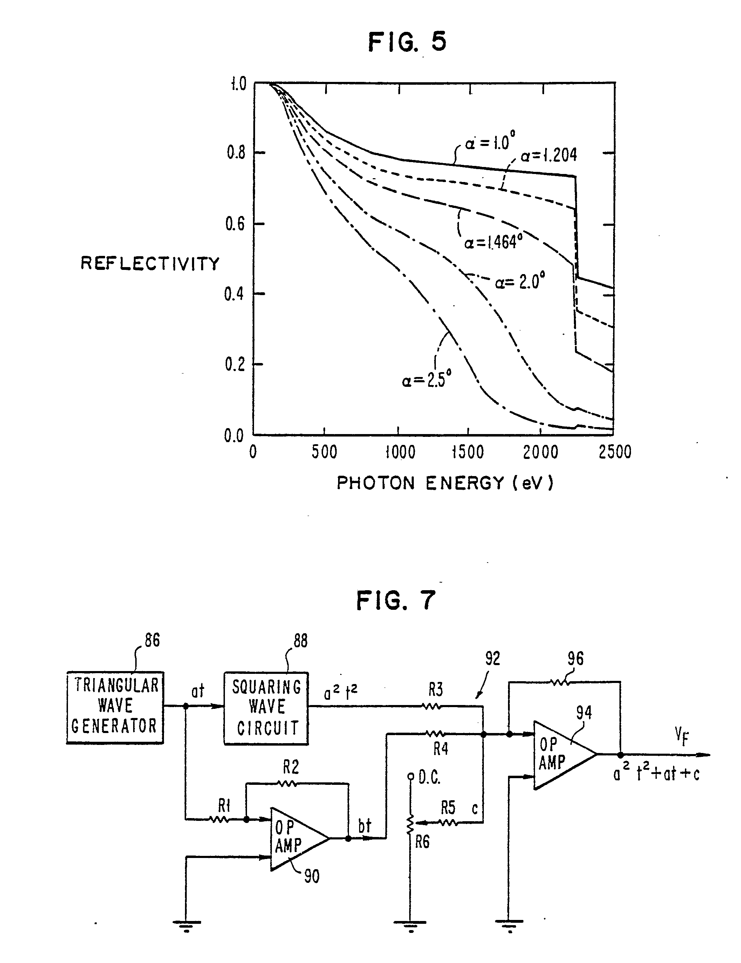

The reflectivity of a gold-coated mirror at five different grazing angles is plotted in Fig. 5, for different photon energies. As is apparent from that plot, the reflectivity is a function of the grazing angle as well as the photon energy (and, consequently, the wavelength). It is desired to have a high reflectivity, since this means that most of the input beam 32 will be delivered to the mask plane as part of the scanning beam 36. In Fig. 5, it is apparent that the highest reflectivities are obtained when the grazing angle $\alpha$ is small. In an x-ray lithography system of the type being described herein, it is preferable to use grazing angles less than about 2°, and typically grazing angles less than 1.5° are chosen. In a useful system, there is a large separation between the mirror 28 and the mask plane, so that the grazing angle $\alpha$ need be changed by only a small amount in order to deflect the scanning beam arc 38 (Fig. 3) over a large area. Since only a small change in $\alpha$ is required when the mirror-mask plane distance is great, it is easy to quickly move the mirror and also its reflectivity changes very little. This means that the efficiency of transfer of energy from the input beam 32 to the scanning beam 36 remains essentially the same over the entire range of scanning angle $\alpha$.

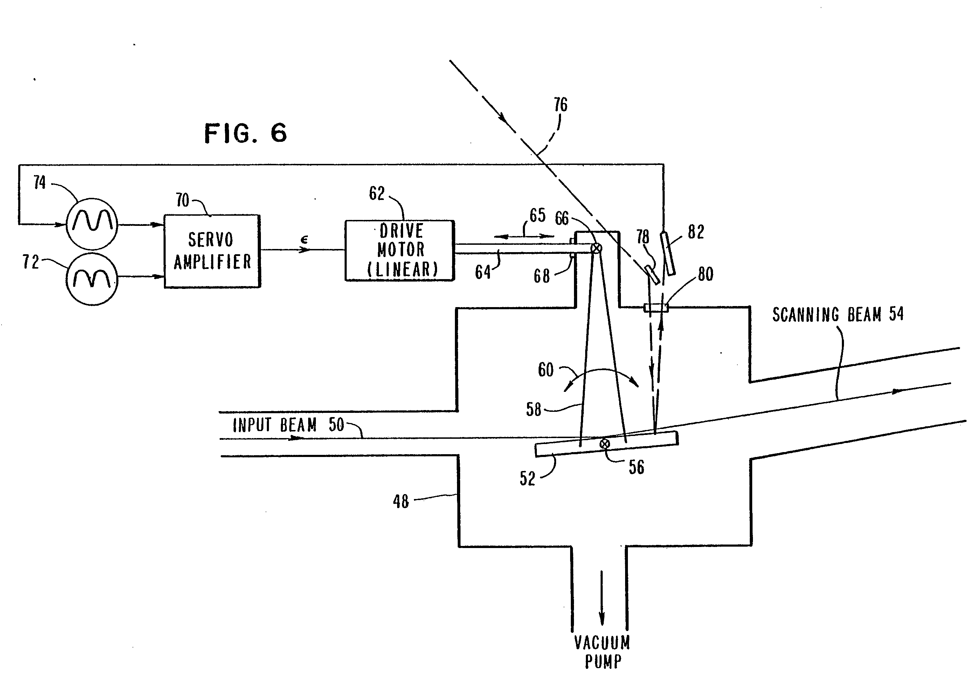

Fig. 6 shows an apparatus for scanning a beam of radiation across a two dimentional area, such as a mask to be illuminated by x-ray radiation. In this apparatus, a closed loop servo system is used to adjust the angle $\alpha$ as a function of time in order to provide uniform Y—Z illumination.

The apparatus is comprised of a vacuum chamber 48 into which the input beam 50 from the radiation source enters. Cylindrical collimating mirror 52 is struck at a grazing angle $\alpha$ by the input beam, to produce the scanning beam 54 that strikes the area to be illuminated. Mirror 52 pivots about the pivot point 56, and is moved by the reciprocating motion of support member 58, which moves back and forth in the direction of arrow 60. The reciprocating motion of support member 58 is caused by a linear drive motor 62, which is coupled to support 58 by the connecting rod 64, which reciprocates in motion as shown by arrow 65. Rod 64 is connected to support 58 at a pivot point 66, and enters the vacuum chamber via a vacuum feedthrough 68.

A servo amplifier 70 provides an error signal $\epsilon$ to the drive motor 62, the error signal being developed as a result of a comparison between a reference signal and a signal indicating the position of mirror 52. The reference signal $V_f$ is provided by source 72 in a manner to be described later. The signal $V_m$ indicating the physical position of mirror 52 is provided by source 74, in accordance with the signal received from a detector used to determine the mirror position. Source 74 is a conventional voltage source that is commerically available, for example, a triangular wave generator.

In order to provide the signal $V_m$, a laser beam indicated by arrow 76 is directed to a mirror 78 and then transmitted through a window 80 to the surface of cylindrical mirror 52. After reflection by mirror 52, the laser beam again passes through window 80 and strikes a silicon linear position detector 82. Detector 82 produces an electrical signal indicative of the angle $\alpha$ which is sent to source 74, via conductor 84. Signals $V_f$ and $V_m$ are compared in the servo amplifier 70, producing an error signal $\epsilon$ if $V_m$ and $V_f$ are not equal. Thus, the mirror position ($\alpha$) is changed as a function of time in a manner which will depend upon the reference signal. As will be seen, the reference signal changes with time in a manner to provide substantially uniform illumination of the entire area to be illuminated. That is, the velocity of change of the mirror position is chosen to provide equal illumination on all points of the area to be illuminated.

Fig. 7 illustrates a circuit which is suitable for providing the reference voltage $V_f$. This circuit produces a voltage which is sufficient to make the incident radiation flux at any point substantially equal to that at any other point. It takes into account the fact that the length of each arc 44A—44F (Fig. 4) varies with the angle $\alpha$. The arc length is a linear function of the angle $\alpha$, the radiation flux at any point along an arc being inversely proportional to the arc length. Then the product of flux and velocity of movement of the mirror can be made a constant if the position x at any point in the mask is in general, nonlinear in time, for example given by an expression such as

$$x(t)=a^2t^2+bt+c. \ldots,$$

where a, b, c . . ., are constants. If the product of flux and velocity is a constant, and if the change of arc length with $\alpha$ is taken into account, then a reference voltage $V_f$ which is a nonlinear function of time can provide uniform illumination at each point of the area to be scanned by the beam.

An example of a circuit to accomplish this goal, in the case in which $\alpha(t)$ is quadratic in time, is shown using a triangular wave generator 86 of a commercially available type which provides a triangular wave output (at) to a squaring wave circuit 88, and also as one input to an operational amplifier 90, via resistor R1. The other input to operational amplifier 90 is grounded. The feedback resistor R2 is used to adjust the gain of amplifier 90, the output of amplifier 90 being (bt). Squaring wave circuit 88 produces $a^2t^2$ at its output, which is fed to a summing network 92, and combined thereat with the voltage (bt), and a DC offset c. Resistors R3, R4, and R5 are located at the input of the summing network. The DC offset is produced from the variable resistance R6, across which a DC voltage is applied. The output of summing network 92 is one input to another operational amplifier 94, having a feedback resistance 96 which is used to adjust the gain of this amplifier. The other input to amplifier 94 is grounded, the output of amplifier 94 being the quadratic voltage $V_f=a^2t^2+bt+c$. This reference voltage is one input to the servo amplifier 70 in Fig. 6. Thus, reference signal source 72 in Fig. 6 is the circuit shown in Fig. 7. Similarly, other circuits which include other analog components, can provide other nonlinear (in time) reference voltages.

While it has been found that a simple nonlinear reference voltage relating the position x of any point on the mask to be illuminated to time is adequate to provide substantially uniform illumination over the entire mask area, it will be understood by those of skill in the art that the incident radiation flux can be measured at each position along each of the arcs of radiation. This data can be stored for each angle of tilt of the cylindrical mirror into a random access memory. Using a standard, commercially available microprocessor, a program can be written wherein the mirror position voltage $V_m$ is compared to the reference voltage resulting from measurement of flux at each point. In this manner a more sophisticated error signal can be developed for driving the motor 62 in Fig. 6.

The principles of this invention are applicable to radiation beams other than x-ray radiation. For example, photons and electron beams can be collimated in one direction and scanned in a second, transverse direction, using the apparatus of this invention. Thus, a photon beam which is scanned horizontally to provide a fan of radiation in a horizontal direction can be moved in a vertical direction by impinging upon the cylindrical mirror, whose tilt is changed as a function of time to produce uniform illumination on an area. A variable velocity of tilt is especially necessary if the photon beam is scanned horizontally with a sinusoidal motion, since the horizontal fan will have a higher intensity at its edges than at its middle. In the practice of this invention, these intensity changes along a horizontal arc of radiation are balanced to provide uniform area illumination.

It should also be understood that the grazing angle that is utilized can be varied from the very small angles which have been mentioned herein. While it is advantageous to use small grazing angles which are changed by only small amounts, the efficiency of reflection from the mirror will depend upon the wavelength of the incident radiation, as is apparent in Fig. 5. Thus, grazing angles greater than 2° may be suitable for use in a system where the input radiation is of an optical wavelength, such as visible light.

As an example, an x-ray lithography system was modelled in which cylindrical mirrors had focal lengths ranging from 3.5 to 7 cms, where the source-mirror distance was 2 m and the mirror-mask distance was 8 m. A line of radiation of width w=5 cms was produced in the mask plane. For grazing angles α of incidence from 1.3° to 1.5°, the scan beam was swept vertically with an instantaneous intensity that was 3.2 to 5.0 times that for a plane mirror, the cylindrical mirror having a focal length of cms and a radius of 10 cms. At these angles of incidence, the transmission of radiation at x-ray lithography wavelengths from the mirror is approximately 70%.

The angle α is made a periodic function of time and has a fundamental frequency sufficiently great that the temperature rise in the mask plane cannot follow the sweep of the radiation arcs across the mask. This leads to uniform mask heating. A fundamental frequency of several Hz (for example about 10—15 Hz, or more) appears to be sufficient, and tailoring of the time dependence α(t) incorporates harmonics much less than 1 KHz for α(t) sufficiently accurate. This is an easily achievable frequency for a mechanical mirror tilting apparatus. Generally, the fundamental frequency is chosen so that substantially uniform heating will occur. This in turn depends on the thermal properties of the mask, thus, if a mask readily carries heat away, than a low fundamental frequency can be used.

## Claims

1. An apparatus for providing substantially uniform illumination across a two-dimensional area (30), comprising a source of an input beam (50) of radiation which is divergent in one direction, reflecting means (52) for collimating said divergent input beam and for providing a reflected output beam (54) to said area (30) to be illuminated, characterised by means (58, 62, 64, 70) for moving said reflecting means (52) with a velocity which varies with time such that the product of the flux in said reflected beam (54) and the velocity of movement of said reflected beam in said area (30) is substantially constant.

2. An apparatus according to claim 1, wherein said drive means includes means (78, 80, 82) for sensing the instantaneous position of said reflecting means (52) and developing a first signal representative thereof, means (72) for producing a reference signal indicating the desired position for said reflecting means at each time, and means (70) for comparing said first signal and said reference signal for producing an output signal for moving said reflecting means (52) to said desired position at any instant time.

3. An apparatus according to claim 2, wherein the position of the illumination of said area at any point x is approximated by a quadratic expression relating said position to time.

4. An apparatus according to any one of the preceding claims, wherein said source is a synchrotron source of x-ray radiation.

5. An apparatus according to any one of the preceding claims, wherein said reflecting means (52) is a mirror of cylindrical shape.

6. An apparatus according to any one of the preceding claims, wherein said area to be illuminated is a lithography mask (10).

7. An apparatus according to claim 6, wherein the angle ($\alpha$) between said input beam (50) and said reflecting means (52) is changed as a periodic function of time with a fundamental frequency sufficiently great that the temperature rise in the plane of said lithography mask cannot follow the sweep of radiation across said mask plane.

8. An apparatus according to any one of said preceding claims, wherein the distance between said source and said reflecting means (52) is less than the distance between said reflecting means (52) and said area (30).

9. An apparatus according to any one of the preceding claims, wherein said angle ($\alpha$) is less than approximately 2°.

10. A method for providing substantially uniform illumination of a two dimensional area with an input beam (50) which is divergent in one direction, which method comprises sending said beam (50) from a source to a reflecting means (52) from which it is reflected to said area (30) to be illuminated and collimating said beam to provide a collimated reflected beam (54) to said area, characterised by changing the angle between said input beam (50) and said reflecting means (52) such that the product of the flux in said reflected beam (54) and the velocity of movement of said beam is approximately constant with time as said reflected beam moves across said area (30).

11. A method according to claim 10, wherein the position of said reflected beam at any point x in said area (30) to be illuminated is approximated by a quadratic function relating said position to time.

12. A method according to claim 10 or 11, wherein the angle ($\alpha$) between the beam (50) and said reflecting means (52) is less than 2°.

13. A method according to claim 10, 11 or 12, wherein said angle is changed as a function of time with a fundamental frequency sufficiently high to lead to uniform heating across said area.

## Patentansprüche

1. Gerät zur Erzeugung einer im wesentlichen gleichförmigen Beleuchtung eines zweidimensionalen Bereichs (30), bestehend aus einer Quelle zur Erzeugung eines einfallenden Strahls (50) einer in einer Richtung divergenten Strahlung, einem reflektierenden Mittel (52) zur Kollimation des genannten divergierenden einfallenden Strahls und zur Erzeugung eines reflektierten Ausgangsstrahls (45), der auf den zu beleuchtenden Bereich (30) fällt, gekennzeichnet durch Antriebsmittel (58, 62, 64, 70) zur Bewegung des genannten reflektierenden Mittels (52) mit einer Geschwindigkeit, die sich zeitlich ändert, so daß das Produkt aus dem Lichtstrom im genannten reflektierten Strahl (54) und der Bewegungsgeschwindigkeit des genannten reflektierten Strahls in dem genannten Bereich (30) im wesentlichen konstant bleibt.

2. Gerät gemäß Anspruch 1, in dem die genannten Antriebsmittel Mittel (78, 80, 82) beinhalten, die die augenblickliche Stellung des genannten reflektierenden Mittels (52) bestimmen und ein erstes, dafür repräsentatives Signal erzeugen, ferner Mittel (72) zur Erzeugung eines Bezugssignals, das jeden Augenblick die Sollstellung des genannten reflektierenden Mittels angibt, sowie Mittel (70) zum Vergleichen des genannten ersten Signals mit dem genannten Bezugssignal beinhalten, die in jedem Augenblick ein Ausgangssignal zur Bewegung des genannten reflektierenden Mittels (52) in seine Sollstellung erzeugen.

3. Gerät gemäß Anspruch 2, in dem die Stellung der Beleuchtung des genannten Bereichs an jedem Punkt x durch einen quadratischen Ausdruck approximiert wird, der die genannte Stellung zur Zeit in Beziehung setzt.

4. Gerät gemäß einem beliebigen der vorstehenden Ansprüche, in dem es sich bei der genannten Strahlungsquelle um eine Synchrotronquelle für Röntgenstrahlung handelt.

5. Gerät gemäß einem beliebigen der vorstehenden Ansprüche, in dem es sich bei dem genannten reflektierenden Mittel (52) um einen zylindrischen Spiegel handelt.

6. Gerät gemäß einem beliebigen der vorstehenden Ansprüche, in dem der genannte zu beleuchtende Bereich eine lithographische Maske ist.

7. Gerät gemäß Anspruch 6, in dem sich der Winkel ($\alpha$) zwischen dem genannten einfallenden Strahl (50) und dem genannten reflektierenden Mittel (52) als periodische Funktion der Zeit ändert mit einer Grundfrequenz, die hinreichend groß ist, daß der Temperatur-anstieg in der genannten lithographischen Maske dem Überstreichen der genannten Maskenfläche durch die Strahlung nicht folgen kann.

8. Gerät gemäß einem beliebigen der vorstehenden Ansprüche, in dem der Abstand zwischen der genannten Quelle und dem reflektierenden Mittel (52) kleiner ist als der Abstand zwischen dem genannten reflektierenden Mittel (52) und dem genannten Bereich (30).

9. Gerät gemäß einem beliebigen der vorstehenden Ansprüche, in dem der genannte Winkel ($\alpha$) kleiner als etwa 2° ist.

10. Verfahren zum Erzeugen einer im wesentlichen gleichförmigen Beleuchtung eines zweidimensionalen Bereichs durch einen einfallenden Strahl (50), der in einer Richtung divergiert, wobei dieses Verfahren umfaßt: Das Senden des genannten Strahls (50) aus einer Quelle auf ein reflektierendes Mittel (52), von dem aus er auf den genannte zu beleuchtenden Bereich (30) reflektiert wird, und Kollimation des genannten Strahls zwecks Erzeugung eines kollimierten auf den genannten ereich fallenden Reflexionsstrahls (54), gekennzeichnet durch die Änderung des Winkels zwischen dem genannten Einfallsstrahl (50) und dem genannten reflektierenden Mittel (52), so daß das Produkt aus dem Lichtstrom im genannten Reflexionsstrahl (54) und der Bewegungsgeschwindigkeit des genannten Strahls mit der Zeit in etwa konstant bleibt, wenn der genannte Reflexionsstrahl über den genannten Bereich (30) streicht.

11. Verfahren gemäß Anspruch 10, in dem die Stellung des genannten Reflexionsstrahls an jedem Punkt x des genannten zu beleuchtenden Bereichs (30) durch eine quadratische Funktion, die die genannte Stellung mit der Zeit in Beziehung setzt, approximiert wird.

12. Verfahren gemäß Anspruch 10 oder 11, in dem der genannte Winkel (α) zwischen dem Strahl (50) und dem genannten reflektierenden Mittel (52) weniger als 2° beträgt.

13. Verfahren gemäß Anspruch 10, 11 oder 12, in dem der genannte Winkel als Funktion der Zeit mit einer Grundfrequenz geändert wird, die hinreichend groß ist, die genannte Fläche gleichmäßig zu erwärmen.

**Revendications**

1. Appareil pour réaliser une illumination sensiblement uniforme sur une surface à deux dimensions (30), comprenant une source de faisceau d'entrée (50) de rayonnement qui est divergent dans un sens, un moyen réfléchissant (52) pour collimater le faisceau d'entrée divergent et pour réaliser un faisceau de sortie réfléchi (54) vers la surface (30) à illuminer, caractérisé par des moyens (58, 62, 64, 70) pour déplacer le moyen réfléchissant (42) à une vitesse qui varie dans le temps de telle manière que le produit du flux dans le faisceau réfléchi (54) et de la vitesse du mouvement du faisceau réfléchi sur la surface (30) soit sensiblement constant.

2. Appareil selon la revendication 1, dans lequel le moyen de commande comprend des moyens (78, 80, 82) pour détecter la position instantanée du moyen réfléchissant (52) et produire un premier signal représentatif de celle-ci, un moyen (72) pour produire un signal de référence indiquant la position désirée chaque fois pour le moyen réfléchissant, et un moyen (70) pour comparer le premier signal et le signal de référence afin de produire un signal de sortie pour déplacer le moyen réfléchissant (52) à tout instant jusqu'à la position désirée.

3. Appareil selon la revendication 2, dans lequel la position de l'illumination de la surface en tout point x est approchée par une expression quadratique associant la position au temps.

4. Appareil selon l'une quelconque des revendications précédentes, dans lequel la source est une source de rayonnement synchrotron de rayons x.

5. Appareil selon l'une quelconque des revendications précédentes, dans lequel le moyen réfléchissant (52) est un miroir de forme cylindrique.

6. Appareil selon l'une quelconque des revendications précédentes, dans lequel la surface à illuminer est un masque lithographique (10).

7. Appareil selon la revendication 6, dans lequel l'angle (α) entre la faisceau d'entrée (50) et le moyen réfléchissant (52) change comme une fonction périodique du temps avec une fréquence fondamentale suffisamment grande pour que la hausse de la température dans le plan du masque lithographique ne puisse suivre le balayage du rayonnement sur le plan du masque.

8. Appareil selon l'une quelconque des revendications précédentes, dans lequel la distance entre la source et le moyen réfléchissant (52) est inférieure à la distance entre le moyen réfléchissant (52) et la surface (30).

9. Appareil selon l'une quelconque des revendications précédentes, dans lequel l'angle (α) est inférieur à environ 2°.

10. Procéde pour réaliser une illumination sensiblement uniform d'une surface à deux dimensions à l'aide d'un faisceau d'entrée (50) divergent dans un sens, lequel procédé comprend l'envoi du faisceau (50) depuis une source jusqu'à un moyen réfléchissant (52) d'où il est réfléchi vers la surface (30) à illuminer, et collimater le faisceau pour réaliser un faisceau réfléchi collimaté (54) sur la surface, caractérisé par la variation de l'angle entre le faisceau d'entrée (50) et le moyen réfléchissant (52) de telle manière que le produit du flux dans le faisceau réfléchi (54) et de la vitesse de déplacement du faisceau est à peu près constant dans le temps lorsque le faisceau réfléchi balaye la surface (30).

11. Procédé selon la revendication 10, dans lequel la position du faisceau réfléchi en tout point x de la surface (30) à illuminer est approché par une fonction quadratique associant la position au temps.

12. Procédé selon la revendication 10 ou 11, dans lequel l'angle (α) entre le faisceau (50) et le moyen réfléchissant (52) est inférieur à 2°.

13. Procédé selon la revendication 10, 11 ou 12, dans lequel l'angle varie en fonction du temps avec une fréquence fondamentale suffisamment grande pour conduire à un chauffage uniforme de toute la surface.

# FIG. 1

# FIG. 2

$$\triangle \psi \sim \frac{2mc^2}{E}\left(\frac{\lambda}{\lambda_c}\right)^{\frac{1}{3}}$$

# FIG. 3

# FIG. 4

## FIG. 5

## FIG. 7

FIG. 6